Europäisches Patentamt

**European Patent Office**

**Office européen des brevets**

(19)

(11) Numéro de publication: **0 141 941**
**B1**

(12)

# FASCICULE DE BREVET EUROPÉEN

(45) Date de publication du fascicule du brevet:
18.03.87

(51) Int. Cl.⁴: **B 05 C 3/12, C 04 B 41/45**

(21) Numéro de dépôt: **84110209.8**

(22) Date de dépôt: **28.08.84**

(54) **Dispositif pour déposer une couche de silicium polycristallin sur un ruban de carbone.**

(30) Priorité: **30.08.83 FR 8313915**

(43) Date de publication de la demande:
**22.05.85 Bulletin 85/21**

(45) Mention de la délivrance du brevet:
**18.03.87 Bulletin 87/12**

(84) Etats contractants désignés:
**AT BE CH DE FR GB IT LI LU NL SE**

(56) Documents cité:
**DE-A-2 554 354**
**DE-B-1 286 510**
**US-A-2 577 904**
**US-A-3 429 734**
**US-A-4 299 648**

(73) Titulaire: **COMPAGNIE GENERALE D'ELECTRICITE**
**Société anonyme dite:, 54, rue La Boétie, F-75382**
**Paris Cedex 08 (FR)**
Titulaire: **SOCIETE NATIONALE ELF AQUITAINE,**
**Tour Aquitaine - Cédex 4, F-92080 Paris la**
**Défense (FR)**

(72) Inventeur: **Belouet, Christian, 138, rue Houdan,**
**F-92330 Sceaux (FR)**

(74) Mandataire: **Weinmiller, Jürgen, Lennéstrasse 9,**
**D-8133 Feldafing (DE)**

EP 0 141 941 B1

## Description

La présente invention concerne un dispositif pour déposer une couche de silicium polycristallin sur un ruban de carbone, du type comportant un creuset contenant un bain de silicium fondu, un ruban de carbone plongé au moins partiellement dans le bain et traversant verticalement, dans le sens de la longueur du ruban, la surface d'équilibre du bain, et des moyens pour déplacer progressivement le ruban verticalement de bas en haut, de façon à déposer ladite couche sur les faces du ruban.

Dans un dispositif connu de ce type, décrit dans le document FR-A-2 386 359 le fond du creuset comporte une fine ouverture par laquelle le ruban pénètre dans le bain et le traverse verticalement en circulant de bas en haut.

Ce dispositif présente un inconvénient. On constate en effet que l'épaisseur de la couche de silicium déposée sur les faces du ruban décroît rapidement lorsqu'on s'approche des deux bords latéraux du ruban. Il en résulte que la couche de silicium déposée présente, le long de ces deux bords latéraux, respectivement deux bandes latérales dont les caractéristiques physiques sont détériorées par rapport à celles de la partie médiane de la couche. Ces bandes latérales sont pratiquement inutilisables notamment pour réaliser des photopiles solaires.

La présente invention a pour but de pallier cet inconvénient.

Elle a pour objet un dispositif pour déposer une couche de silicium polycristallin sur un ruban de carbone, du type spécifié ci-dessus, caractérisé en ce qu'il comporte en outre deux goulottes verticales à section semi-circulaire, plongeant partiellement dans ledit bain et entourant chacune un bord latéral du ruban, et des supports sur lesquels sont fixés ces goulottes et qui s'appuyent sur la paroi du creuset, de façon que le niveau du bain soit élevé par capillarité à proximité des bords latéraux du ruban.

Une forme particulière d'exécution de l'objet de la présente invention est décrite ci-dessous, à titre d'exemple, en référence au dessin annexé dans lequel

- la figure 1 est une vue en perspective d'un dispositif connu par le document FR-A-2.380.359, coupé partiellement suivant un plan vertical

- la figure 2 est une vue schématique montrant la forme de l'isotherme de cristallisation du silicium par rapport au niveau du bain, dans un dispositif du type représenté sur la figure 1,

- la figure 3 est une vue en coupe transversale d'un ruban de carbone revêtu de silicium, le revêtement étant obtenu par un procédé connu utilisant le dispositif illustré par la figure 1,

- la figure 4 représente une vue en perspective d'un mode de réalisation du dispositif selon l'invention, coupé partiellement suivant un plan vertical.

- la figure 5 est une vue de dessus, en plan, du dispositif illustré par la figure 4,

- la figure 6 est une vue en coupe verticale du dispositif illustré par la figure 4

- et la figure 7 est un schéma montrant différentes formes d'isothermes de cristallisation qu'il est possible d'obtenir à l'aide du dispositif selon l'invention.

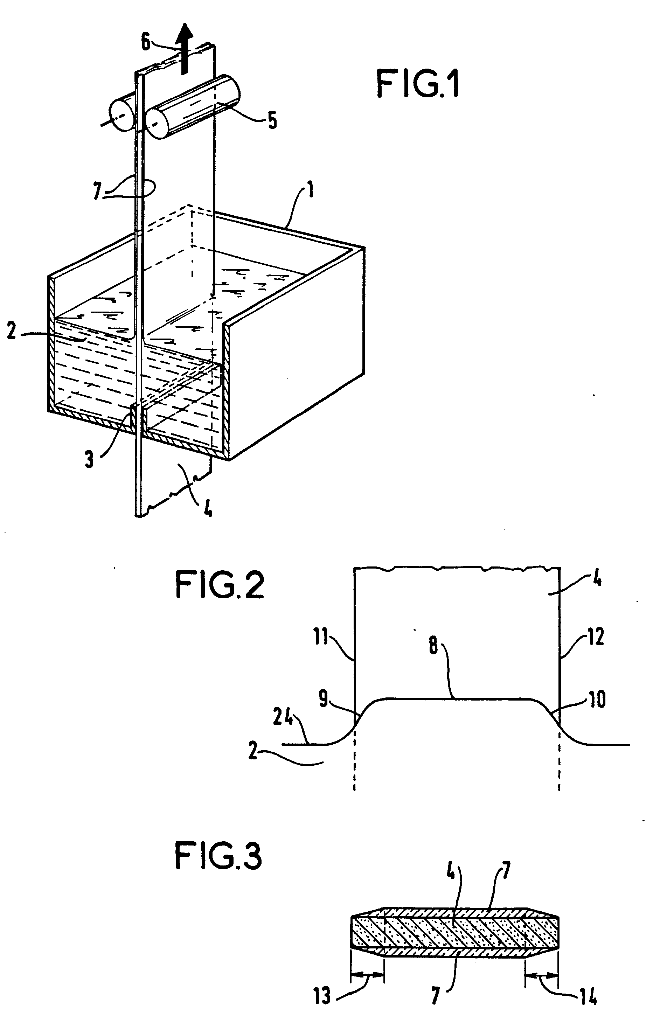

Sur la figure 1, est représenté un creuset parallélépipédique en silice 1 contenant un bain 2 de silicium fondu. Le fond du creuset 1 comporte une fine ouverture linéaire 3 à travers laquelle passe verticalement un ruban de carbone 4 qui sort du bain 2 en traversant sa surface d'équilibre horizontale. La largeur de l'ouverture est déterminée pour que le ménisque de raccordement du silicium liquide soit stable dans cette ouverture. Le dispositif comporte, de plus, des moyens de chauffage non représentés disposés autour du creuset 1 pour maintenir le silicium à l'état liquide.

En fonctionnement, lorsque le ruban 4 se déplace dans le sens de la flèche 6, une couche 7 de silicium polycristallin se dépose sur les deux faces du ruban à la sortie du bain.

La figure 2 représente la forme de l'isotherme de cristallisation sur le ruban 4, c'est-à-dire la ligne de raccordement du ménisque de silicium liquide avec la couche de silicium déposée. On voit que dans la partie médiane de la couche, cette ligne est pratiquement un segment de droite 8 horizontal situé au dessus du niveau 24 du bain. Par contre, dans les deux parties latérales de la couche, cette ligne descend rapidement vers le niveau du bain pour former deux éléments de courbe 9 et 10 dont la concavité est tournée vers le bas.

Il en résulte que l'épaisseur de silicium déposée decroit rapidement lorsqu'on s'approche des bords 11 et 12 du ruban. Cette décroissance est visible sur la figure 3, dans les deux bandes latérales 13 et 14 des deux couches de silicium déposées sur le ruban 4. Lors du refroidissement, des contraintes thermoélastiques, dues aux différences de coefficients de dilatation entre le silicium et le carbone du ruban, se développent dans les couches de silicium. Ces contraintes augmentent lorsque l'épaisseur de silicium décroit. Elles entraînent, dans les bandes latérales, la formation de microfractures qui peuvent se propager pendant les opérations de découpe qui suivent habituellement le dépôt des couches.

D'autre part, l'incurvation de la ligne de raccordement dans les bandes latérales détruit l'alignement des grains du silicium déposé, ce qui entraîne une détérioration des propriétés électriques des couches.

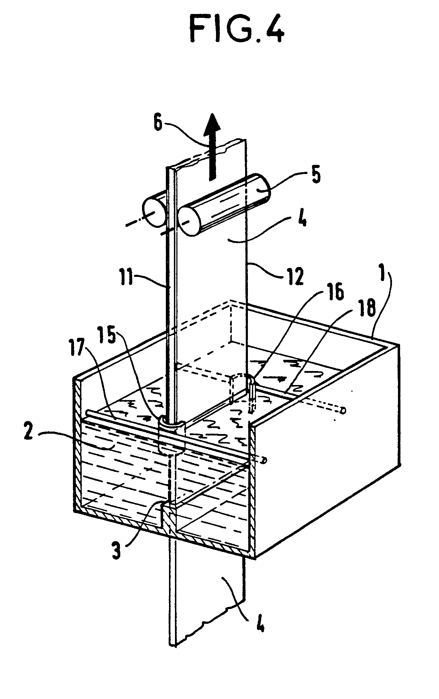

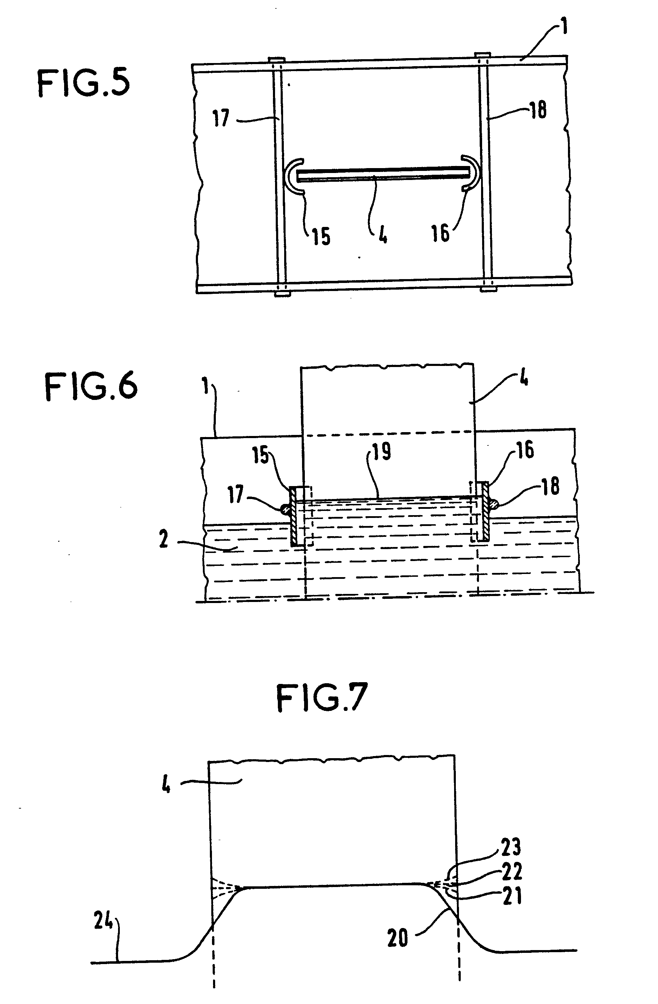

Le dispositif représenté sur les figures 4, 5 et 6 comporte les mêmes éléments que ceux du dispositif illustre par les figures 1 à 3, ces éléments étant désignés par les mêmes références. Suivant une caractéristique de la présente invention, ce dispositif comporte, en outre, deux goulottes 15 et 16 à section semi-circulaire. Ces goulottes peuvent être formées, par exemple, respectivement par deux demi-tubes, résultant de la section d'un tube circulaire par un plan axial. Les goulottes qui peuvent être en quartz, sont fixées par leurs faces convexes, par soudure autogène, respectivement sur des tiges en quartz 17 et 18 dont les extrémités sont elles mêmes fixées sur les bords des parois verticales du creuset 1. Ces tiges permettent de maintenir les goulottes 15 et 16 verticalement respectivement de part et d'autre des deux bords latéraux 11 et 12 du ruban 4, la concavité de ces goulottes étant tournée vers ces bords. Les goulottes 15 et 16 sont partiellement immergées dans le bain 12, de façon à élever son niveau, par capillarité, au voisinage des bords latéraux du ruban. Dans le dispositif illustré par les figures 4 à 6, les goulottes 15 et 16 ont été disposées par rapport aux bords du ruban de manière à obtenir une isotherme de cristallisation 19 rectiligne sur toute la largeur du ruban 4 (voir figure 6).

Il est possible de contrôler la montée capillaire du silicium liquide le long des goulottes en faisant varier les paramètres suivants:

- diamètre intérieur des goulottes,
- distance et orientation des goulottes par rapport aux bords du ruban.

On voit ainsi sur la figure 7 qu'il est possible, en ajustant ces paramètres, de relever l'isotherme de cristallisation sur les bords du ruban par rapport à la courbe 20 obtenue dans l'art antérieur, suivant des courbes telles que 21, 22 et 23. La ligne 21 tourne encore sa concavité vers le niveau 24 du bain, alors que la ligne 22 est rectiligne et la ligne 23 présente une légère concavité vers le haut.

Le dispositif selon la présente invention permet de réaliser des dépôts de silicium sur un ruban de carbone, ces dépôts ne présentant pas les fractures qui apparaissaient dans l'art antérieur. De plus, la surface utile des dépôts est nettement augmentée. Enfin les propriétés électriques des couches de silicium déposées sont améliorées.

Ce dispositif selon la présente invention peut être appliqué à la réalisation de photopiles solaires.

## Revendication

1. Dispositif pour déposer une couche (7) de silicium polycristallin sur un ruban de carbone, comportant
- un creuset (1) contenant un bain (2) de silicium fondu,
- un ruban (4) de carbone plongé au moins partiellement dans le bain et traversant verticalement, dans le sens de la longueur du ruban, la surface d'équilibre du bain
- et des moyens pour déplacer progressivement le ruban (4) verticalement de bas en haut, de façon à déposer ladite couche sur les faces du ruban,

caractérise en ce qu'il comporte en outre deux goulottes verticales (15, 16) à section semi-circulaire, plongeant partiellement dans ledit bain (2) et entourant chacune un bord latéral (11, 12) du ruban (4)

et des supports (17, 18) sur lesquels sont fixés ces goulottes et qui s'appuyent sur la paroi du creuset (1), de façon que le niveau du bain soit élevé par capillarité à proximité des bords latéraux du ruban.

## Patentansprüche

Vorrichtung zum Aufbringen einer Schicht aus polykristallinem Silizium (7) auf ein Karbonband, die aufweist
- einen Tiegel (1), der ein Bad (2) aus geschmolzenem Silizium enthält,
- ein Karbonband (4), das zumindest teilweise in das Bad eingetaucht ist und die Gleichgewichtsoberfläche des Bades senkrecht in Richtung der Länge des Bandes durchquert,
- und Mittel, um das Band (4) nach und nach senkrecht von unten nach oben zu bewegen, um die Schicht auf die Oberseiten des Bandes aufzubringen,

dadurch gekennzeichnet, daß sie außerdem zwei senkrechte Rinnen (15, 16) mit halbkreisförmigem Querschnitt, die teilweise in das Bad (2) eingetaucht sind und je einen Seitenrand (11, 12) des Bandes (4) umgeben, und Träger (17, 18) aufweist, auf denen diese Rinnen befestigt sind und die sich an der Wand des Tiegels (1) abstützen, so daß der Pegel des Bades durch Kapillarität in der Nähe der Seitenränder des Bandes erhöht wird.

## Claim

A device for depositing a layer (7) of polycristalline silicon on a carbon tape, comprising
- a crucible (1) containing a bath (2) of molten silicon,
- a carbon tape (4) immerged at least partially in said bath and passing vertically and in the direction of the length of the tape through the equilibrium surface of the bath,
- and means for moving progressively the tape (4) from the bottom to the top so as to deposit said layer on the faces of the tape,

characterized in that it further comprises two vertical spouts (15, 16) of semi-circular cross-section partially immerged in said bath (2) and surrounding each a lateral edge (11, 12) of the tape,

and supports (17, 18) on which these spouts are fixed and which are supported by the wall of the crucible (1), so that the surface of the bath is raised by capillary action in the vicinity of the lateral edges of the tape.

0 141 941

FIG.1

FIG.2

FIG.3

# FIG.4

FIG.5

FIG.6

FIG.7